# EUROPÄISCHE PATENTANMELDUNG

(11) **EP 0 632 489 A2**
(43) Veröffentlichungstag der Anmeldung: **04.01.1995**
(21) Anmeldenummer: 94109100.1
(22) Anmeldetag: 14.06.1994
(51) Int. Cl.: H01L 21/331, H01L 29/735

(54) **Herstellungsverfahren für lateralen Bipolartransistor**

(30) Priorität: 02.07.1993 DE 4322135
(71) Anmelder: SIEMENS AKTIENGESELLSCHAFT, D-80333 München (DE)
(72) Erfinder: Bertagnolli, Emmerich, Dr., D-80799 München (DE); Klose, Helmut, Dr., D-81929 München (DE)

(57) **Zusammenfassung**

Verfahren zur Herstellung lateraler Bipolartransistoren auf SOI-Substrat, bei dem in der Siliziumschicht dieses SOI-Substrates eine Grunddotierung für den Leitfähigkeitstyp von Emitter und Kollektor hergestellt wird, außerhalb des für den Transistor vorgesehenen Bereiches Isolationsbereiche (5) hergestellt werden, Kontaktschichten (71, 81) und Dielektrikumschichten (72, 82) über einer durch Maskentechnik hergestellten hoch dotierten Emitterzone (7) und einer hoch dotierten Kollektorzone (8) aufgebracht und strukturiert werden, so daß sich über einer herzustellenden Basiszone (9) in der Mitte zwischen Emitterzone (7) und Kollektorzone (8) ein Graben befindet, dann eine Hilfsschicht (11) ganzflächig konform mit konstanter Dicke (d) abgeschieden wird, wodurch der Graben der Breite (d) zu einem Spalt der Breite (x) der herzustellenden Basiszone (9) vermindert wird, durch diesen Spalt eine Implantation von Dotierstoff für das Vorzeichen der Leitfähigkeit der Basis vorgenommen wird, wobei die lateral zu dieser Basiszone (9) befindlichen Bereiche durch die die Flanken des Grabens bedeckenden vertikalen Anteile der Hilfsschicht (11) abgeschirmt werden, dann Kontaktlöcher in die Hilfsschicht (11) und die Dielektrikumschicht (72, 82) geätzt werden und Metallkontakte für den elektrischen Anschluß von Emitter, Kollektor und Basis hergestellt werden.

## Beschreibung

Die vorliegende Erfindung betrifft ein Verfahren zur Herstellung lateraler Bipolartransistoren in Silizium.

Bei integrierten Bipolartransistoren ist eine vertikal übereinander angeordnete Schichtfolge für Emitter, Basis und Kollektor üblich. In dieser Vertikalanordnung sind jeweils zwei Zonen der Schichtfolge nicht direkt, d. h. von der Oberfläche her, zugänglich, sondern müssen seitlich verlängert und an die Oberfläche geführt werden. Für die unterste dotierte Schicht ist im allgemeinen noch eine weitere, hoch dotierte vergrabene Schicht notwendig, um die Zuleitung zur Oberfläche ausreichend niederohmig zu halten. Der eigentliche Transistor, d. h. die npn-Folge bzw. die pnp-Folge der Schichten, wird nicht fotolithographisch, sondern durch Diffusionsprozesse und Implantationen bestimmt, so daß Dimensionen im Sub-µm-Bereich erreichbar sind. Der Nachteil dieser Anordnung ist, daß vertikale Transistoren eine merkliche Tiefenausdehnung, typischerweise 1 bis 2 µm, und laterale Abmessungen haben, die den eigentlichen Transistorbereich um ein Vielfaches übertreffen. Entsprechend gibt es eine Reihe von parasitären Kapazitäten und Widerständen, die neben der möglichen Einbuße bei der Schaltgeschwindigkeit vor allem den Leistungsbedarf deutlich erhöhen. Daneben ist die Komplexität des Herstellungsprozesses und der Flächenbedarf dieser Bauelemente verglichen mit MOS-Bauelementen sehr hoch und führt zu niedrigen Ausbeuten bei hohem Herstellungsaufwand. Die gleichzeitige Herstellung komplementärer Strukturen (npn- und pnp-Transistoren) z. B. für analoge Anwendungen ist nur unter erheblichem Aufwand möglich.

Bei lateral angeordneten Bipolartransistoren werden üblicherweise die Bereiche für Emitter und Kollektor in ein größeres Basisgebiet eingebettet, so daß auch diese Transistoren eine relativ weite Ausdehnung in der Tiefe besitzen. Ein einfaches Herstellungsverfahren für derartige laterale Transistoren ist bisher nicht bekannt.

Aufgabe der vorliegenden Erfindung ist es, ein einfaches Verfahren anzugeben für die Herstellung von lateralen Bipolartransistoren für die Anwendung im Bereich niedrigster Leistung und reduzierter Versorgungsspannungen, wobei dieses Verfahren die Integration von npn- und pnp-Transistoren in einem Bauelement problemlos ermöglichen soll.

Diese Aufgabe wird mit dem Verfahren mit den Verfahrensschritten des Anspruches 1 gelöst. Weitere Ausgestaltungen ergeben sich aus den abhängigen Ansprüchen.

Bei dem erfindungsgemäßen Verfahren werden laterale Bipolartransistoren in einer dünnen Siliziumschicht z. B. eines SOI-Substrates hergestellt. Dabei werden die unterschiedlich dotierten Bereiche für Emitter, Basis und Kollektor durch Implantation von Dotierstoff in eine Grunddotierung unter Verwendung von Masken hergestellt. Im Bereich einer herzustellenden Basiszone wird eine Hilfsschicht ganzflächig konform in einen Graben abgeschieden, wobei sich zwischen den bedeckten Flanken des Grabens ein Spalt der Breite der herzustellenden Basiszone bildet. Durch diesen Spalt wird eine Implantierung für die Basiszone vorgenommen, wobei die an den Grabenflanken senkrecht vorhandenen Anteile der Hilfsschicht als Abschirmung der angrenzenden Bereiche dienen.

Es folgt eine Beschreibung des erfindungsgemäßen Herstellungsverfahrens anhand der Figuren 1 bis 6.
- Fig. 1 bis 3: zeigen einen erfindungsgemäß hergestellten Transistor im Querschnitt nach verschiedenen Schritten des Herstellungsverfahrens.
- Fig. 4 und 6: zeigen alternative Ausführungsformen des erfindungsgemäß hergestellen Transistors im Querschnitt.
- Fig. 5: zeigt den in Fig. 3 eingezeichneten Schnitt.

Bei dem erfindungsgemäßen Verfahren wird vorteilhaft von einem SOI-Substrat (Silicon on Insulator) ausgegangen. Statt eines eigentlichen SOI-Substrates kann auch mit SIMOX hergestelltes Material oder eine entsprechende durch Waferbonding hergestellte Schichtstruktur verwendet werden. Es kommt nur darauf an, daß eine dünne Nutzschicht aus Silizium auf einem isolierenden Untergrund oder einer isolierenden Zwischenschicht aufgebracht ist und mit den üblichen Verfahren der Siliziumtechnik bearbeitet werden kann. Das erfindungsgemäße Verfahren eignet sich gleichermaßen für die Herstellung von npn-Transistoren wie für pnp-Transistoren.

In der Siliziumschicht, die z. B. 2 µm bis 20 nm dick sein kann, wird der für den Transistor vorgesehene Bereich lateral ringsum isoliert und mit einer Grunddotierung versehen. Am einfachsten ist es, wenn die Siliziumschicht zu Beginn des Verfahrens mit einer Grunddotierung einer Dichte von etwa 10¹⁵ bis 10¹⁷ cm⁻³ versehen wird. Das Vorzeichen dieser Dotierung wird für den Leitfähigkeitstyp von Emitter und Kollektor gewählt. Als Beispiel wird bei einem npn-Transistor Phosphor oder Arsen als Dotierstoff zur Grunddotierung eingebracht. Die Isolation außerhalb dieses für den Transistor vorgesehenen Bereiches kann z. B. durch LOCOS erfolgen oder durch Grabenätzung oder dgl. Es kommt auch eine Kombination derartiger Maßnahmen in Frage. Das Silizium der Siliziumschicht kann auch außerhalb dieses Bereiches vollständig entfernt sein, so daß der Transistor in der Art einer Mesa strukturiert wird. In dem in den Figuren dargestellten Ausführungsbeispiel sind die lateralen Isolationsbereiche 5 mittels LOCOS hergestellt.

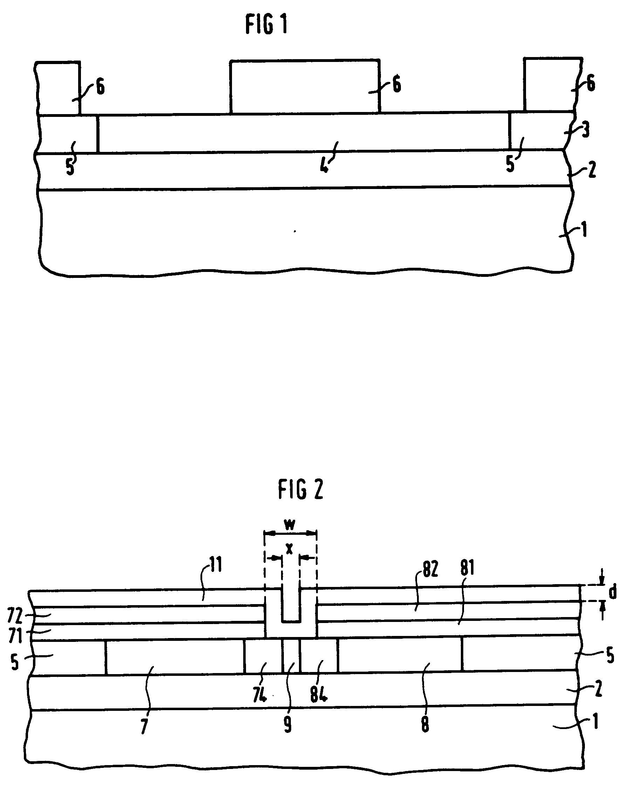

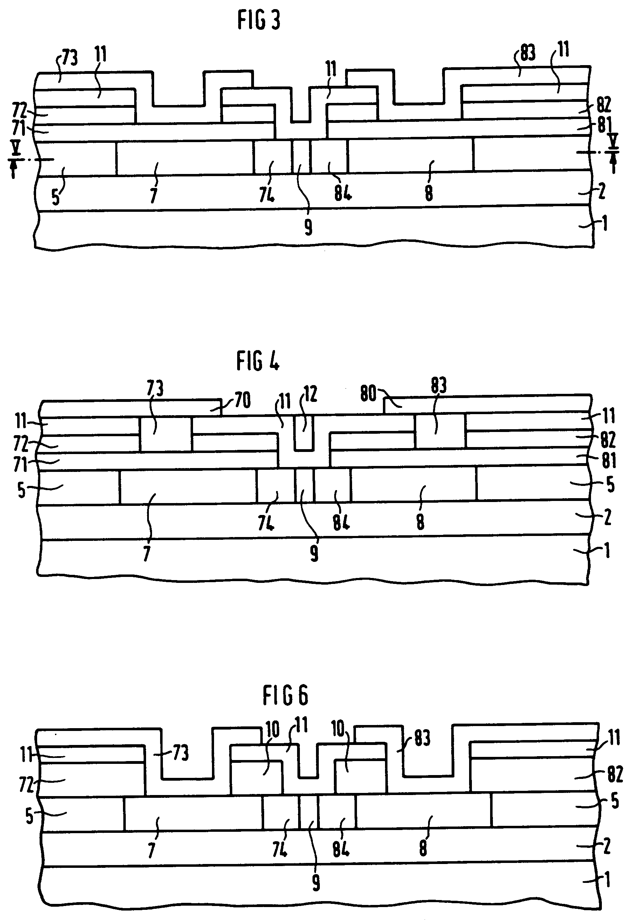

In Fig. 1 sind das Substrat 1, die Isolationsschicht 2 und die Siliziumschicht 3 dargestellt. In der Siliziumschicht 3 sind der mit der Grunddotierung versehene Bereich 4 und die lateralen Isolationsbereiche 5 im Querschnitt dargestellt.

Die Isolationsschicht 2 kann z. B. SiO₂ sein. Unter Verwendung von z. B. mittels Fotolithographie hergestellten Masken 6 werden Implantierungen von Dotierstoffen für die Anschlußgebiete von Emitter, Kollektor und Basis vorgenommen. Die Höhe der Dotierung wird dabei für einen niederohmigen Metall-Halbleiter-Kontakt für die spätere elektrische Kontaktierung gewählt. Damit erhält man die in Fig. 2 dargestellte Emitterzone 7 und Kollektorzone 8. Senkrecht zur Zeichenebene befindet sich die für das entgegengesetzte Vorzeichen hoch dotierte Basisanschlußzone. Bei einem npn-Transistor wird als Dotierstoff für diese Basisanschlußzone z. B. Bor verwendet. Ggf. werden die implantierten Gebiete anschließend einem Ausheilungs- und/oder Diffusionsprozeß unterzogen (z. B. RTA/FA-Prozesse). Bei dem erfindungsgemäßen Verfahren kann die Reihenfolge der Herstellung von Emitterzone und Kollektorzone und von der Basisanschlußzone vertauscht werden.

In einem vorteilhaften Ausführungsbeispiel des erfindungsgemäßen Verfahrens wird dann eine Polysiliziumschicht zur Ausbildung von Kontaktschichten auf dem Silizium über der Emitterzone 7 und der Kollektorzone 8 abgeschieden und für den Leitungstyp von Emitter und Kollektor dotiert. Darauf wird eine Dielektrikumschicht abgeschieden. Die beiden abgeschiedenen Schichten werden wie in der Fig. 2 dargestellt strukturiert, so daß sich auf der Emitterzone 7 eine Kontaktschicht 71 aus Polysilizium und eine Dielektrikumschicht 72 und auf der Kollektorzone 8 eine Kontaktschicht 81 und eine Dielektrikumschicht 82 befinden. Die Strukturierung ist entsprechend Fig. 2 derart, daß in der Mitte zwischen Emitterzone 7 und Kollektorzone 8 diese aufgebrachten Schichten einen Graben längs der herzustellenden Basiszone freilassen. Die Flanken dieses Grabens sind senkrecht. Auf diese Struktur wird ganzflächig konform eine Hilfsschicht 11 abgeschieden. Diese Hilfsschicht 11 hat die gleichmäßige Dicke d. Dadurch wird die Breite w des Grabens zu einem Spalt der Breite x reduziert. Die Breite x dieses Spaltes entspricht der Breite der herzustellenden Basiszone.

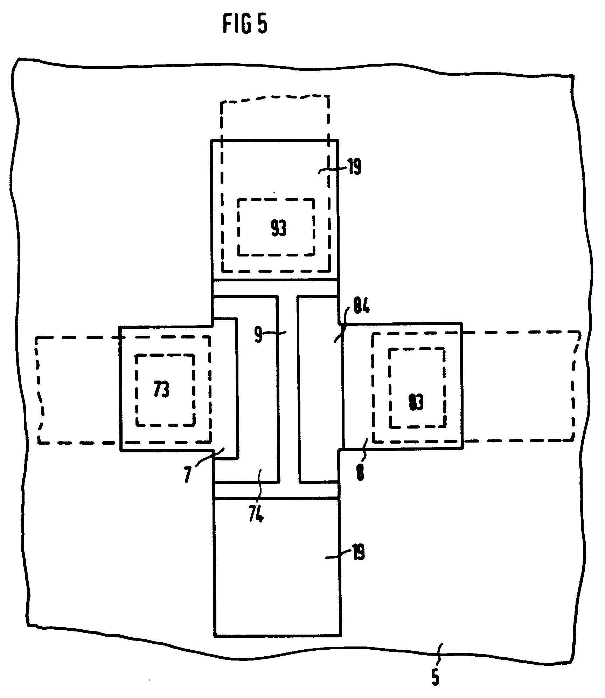

Dann wird ganzflächig der Dotierstoff für diese Basiszone 9 implantiert. Die Energie dieser Implantation wird dabei so eingestellt, daß der Dotierstoff im Bereich des Spaltes problemlos den einkristallinen Bereich der Siliziumschicht erreicht, in den Bereichen seitlich des Spaltes aber von den dort vertikal an den Grabenflanken dicker vorhandenen Anteilen der Hilfsschicht 11 abgeschirmt wird. Auf diese Weise wird erreicht, daß nur der für die Basiszone 9 vorgesehene Bereich unterhalb des Spaltes mit Dotierung versehen wird. Die Breite x der Basiszone 9 kann durch die Breite w des Grabens, d. h. den Abstand der Kontaktschichten 71, 72, und über die Dicke d der abgeschiedenen Hilfsschicht 11 eingestellt werden. Ebenso kann durch die Wahl der Dicke von Kontaktschichten 71, 81 und Dielektrikumschichten 72, 82 sichergestellt werden, daß der Dotierstoff für die Basiszone 9 außerhalb des Bereiches dieser Basiszone nicht den einkristallinen Bereich der Siliziumschicht erreicht. Die Basiszone 9, die auf diese Weise hergestellt wird, wird anschließend ausgeheilt. Zwischen der Basiszone 9 und der hoch dotierten Emitterzone 7 verbleibt eine weitere Emitterzone 74 mit der Grunddotierung. Zwischen der Basis 9 und der hoch dotierten Kollektorzone 8 verbleibt eine weitere Kollektorzone 84 mit der Grunddotierung. Die Hilfsschicht 11 und die Dielektrikumschichten 72, 82 werden unter Zuhilfenahme einer Fototechnik so strukturiert, daß die Emitterzone 7, die Kollektorzone 8 und die Basisanschlußzone ggf. über darauf aufgebrachten Kontaktschichten 71, 81 mit Metallkontakten versehen werden können. Auf der Basisanschlußzone kann ebenfalls eine Kontaktschicht aus Polysilizium aufgebracht werden, die zusammen mit den Kontaktschichten 71, 81 für Emitter und Kollektor aufgebracht werden kann, aber entgegengesetzt dotiert werden muß. Fig. 3 zeigt im Querschnitt den fertigen Transistor mit den aufgebrachten Metallkontakten 73, 83 für den Emitter bzw. den Kollektor. Statt dieser Metallkontakte kann wie in Fig. 4 gezeigt zunächst jedes Kontaktloch mit dem Metallkontakt gefüllt werden und dann auf der Oberfläche eine Anschlußmetallisierung 70, 80 z. B. als Bestandteil von Leiterbahnen darauf aufgebracht werden. Der über der Basiszone 9 befindliche Spalt in der Hilfsschicht 11 kann z. B. durch Abscheiden eines Dielektrikums 12 gefüllt werden. Das ist bei jeder der gezeigten Ausführungsformen möglich.

Der in Fig. 3 eingezeichnete Schnitt ist in Fig. 5 dargestellt. Der Fig. 5 ist die Anordnung der Emitterzone 7, der Kollektorzone 8, der Basiszone 9 und der damit verbundenen Basisanschlußzone 19 zu entnehmen. Gestrichelt sind die Konturen der auf diesen Zonen angebrachten Metallkontakte 73, 83, 93 eingezeichnet.

Bei dem erfindungsgemäßen Verfahren kann als Kontaktschicht 71, 81 statt Polysilizium auch eine Schicht aus Wolfram/TiN oder anderen hochschmelzenden Metallen, Metallverbindungen bzw. Polyciden (Verbindungen von Metall mit Polysilizium) verwendet werden. In diesem Fall kann die erste Metallisierungsebene vollständig mit diesen Materialien ausgeführt werden, so daß zwei Fotolithographieschritte (Kontaktloch und erste Metallisierungsebene) entfallen. Auf die Kontaktschicht kann auch ganz verzichtet werden, wenn die Emitterzone, die Kollektorzone und die Basisanschlußzone nach Fertigstellung der Diffusionsgebiete direkt mit der ersten Metallisierungsebene kontaktiert werden. In diesem Fall wird entsprechend Fig. 6 die Dielektrikumschicht 72, 82 (z. B. SiO₂) direkt auf die Emitterzone 7, die Kollektorzone 8 und die Basisanschlußzone 19 abgeschieden. Diese Dielektrikumschicht 72, 82 wird ggf. entsprechend dicker als in dem vorher beschriebenen Ausführungsbeispiel aufgebracht. In diese Dielektrikumschicht wird zunächst unter Zuhilfenahme einer Fototechnik der Graben über der herzustellenden Basiszone in der Mitte zwischen der Emitterzone 7 und der Kollektorzone 8 hergestellt. Anschließend wird die Hilfsschicht 11 ganzflächig konform, d. h. mit gleichmäßiger Dicke aufgebracht, so daß der Spalt über der Basiszone 9 verbleibt, durch den die Dotierung in die Basiszone 9 eingebracht wird. Die Kontaktlöcher werden dann bis auf die Emitterzone 7, die Kollektorzone 8 und die Basisanschlußzone 19 geätzt, so daß die Metallkontakte 73, 83 wie in Fig. 6 gezeigt direkt auf diesen hoch dotierten Bereichen der ursprünglichen Siliziumschicht aufgebracht werden können.

Die Breite w des Grabens über der Basiszone kann entsprechend der minimalen Auflösung der Fototechnik gewählt werden. Der Abstand zwischen den Kontaktierungen von Emitter und Kollektor ist durch diese geringe Breite w gegeben. Die Basiszone kann bei geeigneter Wahl der Dicke d der Hilfsschicht 11 extrem schmal eingestellt werden. Es können daher mit dem erfindungsgemäßen Verfahren laterale Bipolartransistoren mit extrem geringen Abmessungen symmetrisch und selbstjustiert auf einfache Weise hergestellt werden.

## Patentansprüche

1. Verfahren zur Herstellung eines lateralen Bipolartransistors, bei dem
in einem ersten Schritt in einer Siliziumschicht (3), die sich auf einer Isolationsschicht (2) befindet, ein für einen Transistor vorgesehener Bereich (4) lateral ringsum elektrisch isoliert wird und dieser Bereich (4) mit einer Grunddotierung für den Leitfähigkeitstyp von Emitter und Kollektor versehen wird,
in einem zweiten Schritt unter Verwendung von Masken (6) eine hoch dotierte Emitterzone (7), eine hoch dotierte Basisanschlußzone (19) und eine hoch dotierte Kollektorzone (8) durch Implantation von Dotierstoffen hergestellt werden,
in einem dritten Schritt eine Dielektrikumschicht (72, 82) aufgebracht und so strukturiert wird, daß diese Dielektrikumschicht (72, 82) in der Mitte zwischen dieser Emitterzone (7) und dieser Kollektorzone (8) einen bis auf diese Siliziumschicht (3) reichenden Graben mit senkrechten Flanken aufweist,
in einem vierten Schritt eine Hilfsschicht (11) ganzflächig konform in einer solchen Dicke (d) abgeschieden wird, daß durch die die Flanken dieses Grabens bedeckenden Anteile dieser Hilfsschicht (11) ein streifenförmiger Spalt der Breite (x) einer herzustellenden Basiszone gebildet wird,
in einem fünften Schritt eine Basiszone (9) hergestellt wird, indem unter Verwendung dieser Hilfsschicht (11) als Abschirmung eine Implantation von Dotierstoff für den Leitfähigkeitstyp der Basis vorgenommen wird,
in einem sechsten Schritt in dieser Dielektrikumschicht (72, 82) Kontaktlöcher für den elektrischen Anschluß dieser Emitterzone (7), dieser Basisanschlußzone (19) und dieser Kollektorzone (8) hergestellt werden und
in einem siebenten Schritt Metallkontakte (73, 83, 93) für Emitter, Kollektor und Basis aufgebracht werden.

2. Verfahren nach Anspruch 1, bei dem
zwischen dem zweiten und dem dritten Schritt Kontaktschichten (71, 81) auf die Emitterzone (7) und die Kollektorzone (8) aufgebracht werden und diese Kontaktschichten (71, 81) in dem dritten Schritt entsprechend der Dielektrikumschicht (72, 82) strukturiert werden.

3. Verfahren nach Anspruch 2,
bei dem die Kontaktschichten (71, 81) Polysilizium sind.

4. Verfahren nach Anspruch 2,
bei dem die Kontaktschichten (71, 81) hochschmelzendes Material aus der Gruppe von Metall, Metallverbindung und Polycid sind.
